# EUROPEAN PATENT APPLICATION

(11) **EP 2 466 373 A1**
(43) Date of publication of application: **20.06.2012**
(21) Application number: 11193544.1
(22) Date of filing: 14.12.2011
(51) Int. Cl.: G03B 15/04, F21V 5/04, H01L 33/58

(54) **Flash Lens and Flash Module Employing the Same**

(30) Priority: 15.12.2010 KR 20100128609
(71) Applicant: Samsung LED Co., Ltd., Gyeonggi-do 443-743 (KR)
(72) Inventor: You, Jae-sung, Gyeonggi-do (KR)
(74) Representative: Grünecker, Kinkeldey, Stockmair & Schwanhäusser

(57) **Abstract**

A flash lens and a flash module. The flash lens includes a circular first incidence surface on which light emitted from a light source in a center direction is incident; a second incidence surface arranged to be tilted with respect to an optical axis and on which light emitted from the light source in a lateral direction is incident; a reflective surface that reflects light incident from the second incidence surface; a bottom surface that connects the second incidence surface and the reflective surface; and a circular emission surface that emits light transmitted through the first incidence surface and light reflected by the reflective surface. The flash module includes an LED chip; and the flash lens of claim 1 that is arranged above the LED chip.

## Description

### BACKGROUND OF THE INVENTION

### 1. Field of the Invention

The present invention relates to a flash lens and a flash module employing the same, and more particularly, to a super-slim flash lens in which a peripheral illuminance is improved with respect to a center illuminance and a flash module employing the flash lens.

### 2. Description of the Related Art

A camera flash is a device for providing illumination for capturing a picture when ambient light is insufficient, that is, when additional illumination is necessary. A camera flash may include a light source unit and a lens unit, wherein the light source unit is generally formed of xenon, LED, or the like and the lens unit is generally formed of plastic or glass. Recently, most small electronic devices include small-size cameras, and such small-size cameras also need camera flashes for securing sufficient light for capturing a picture. To include a flash module in a small electronic device, it is necessary that the flash module is slim, and thus research is being actively done on flash lenses for effectively providing sufficient illumination to an imaging region by using a slim flash module.

### SUMMARY OF THE INVENTION

According to an aspect of the present invention, there is provided a flash lens including a circular first incidence surface on which light emitted from a light source in a center direction is incident; a second incidence surface arranged to be tilted with respect to an optical axis and on which light emitted from the light source in a lateral direction is incident; a reflective surface that reflects light incident from the second incidence surface; a bottom surface that connects the second incidence surface and the reflective surface; and a circular emission surface that emits light transmitted through the first incidence surface and light reflected by the reflective surface.

The reflective surface may be a conic surface or an aspheric surface.

The first incidence surface may be a convex surface.

The first incidence surface may be spherical or aspherical.

An angle by which the second incidence surface is tilted with respect to the optical axis may be from 5° to 10°.

A ratio between a length from the bottom surface to an edge of the first incidence surface and a length from the bottom surface to an edge of the emission surface may be from 0.45 to 0.65.

The first incidence surface may be a concave surface.

The first incidence surface may be spherical or aspherical.

The emission surface may be a convex surface.

The emission surface may be spherical or aspherical.

A distance between the light source and the first incidence surface may be from 0.4mm to 4.5mm.

The center direction may be a direction tilted with respect to the optical axis within a range from -45° to +45°.

The lateral direction may be a direction tilted with respect to the optical axis within a range except a range from -45° to +45°.

According to another aspect of the present invention, there is provided a flash module including an LED chip; and the flash lens of claim 1 that may be arranged above the LED chip.

### BRIEF DESCRIPTION OF THE DRAWINGS

The above and other features and advantages of the present invention will become more apparent by describing in detail exemplary embodiments thereof with reference to the attached drawings in which:
FIG. 1A is a schematic perspective view of a flash lens according to an embodiment of the present invention;
FIG. 1B is a sectional view of the flash lens;
FIGS. 2A and 2B are diagrams showing illuminances of the flash lens according to an embodiment of the present invention;
FIG. 3 is a schematic sectional view of a flash lens according to another embodiment of the present invention;
FIGS. 4A and 4B are diagrams showing illuminances of the flash lens according to another embodiment of the present invention;
FIGS. 5A and 5B are diagrams showing correlated color temperature (CCT) of the flash lens according to another embodiment of the present invention.

### DETAILED DESCRIPTION OF THE INVENTION

Various example embodiments will now be described more fully with reference to the accompanying drawings in which some example embodiments are shown.

Detailed illustrative example embodiments are disclosed herein. However, specific structural and functional details disclosed herein are merely representative for purposes of describing example embodiments. This invention may, however, may be embodied in many alternate forms and should not be construed as limited to only the example embodiments set forth herein.

Accordingly, while example embodiments are capable of various modifications and alternative forms, embodiments thereof are shown by way of example in the drawings and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or," includes any and all combinations of one or more of the associated listed items.

It will be understood that when an element or layer is referred to as being "formed on," another element or layer, it can be directly or indirectly formed on the other element or layer. That is, for example, intervening elements or layers may be present. In contrast, when an element or layer is referred to as being "directly formed on," to another element, there are no intervening elements or layers present. Other words used to describe the relationship between elements or layers should be interpreted in a like fashion (e.g., "between," versus "directly between," "adjacent," versus "directly adjacent," etc.).

The terminology used herein is for the purpose of describing particular embodiments only and is not intended to be limiting of example embodiments. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

In the drawings, the thicknesses of layers and regions are exaggerated for clarity. Like reference numerals in the drawings denote like elements.

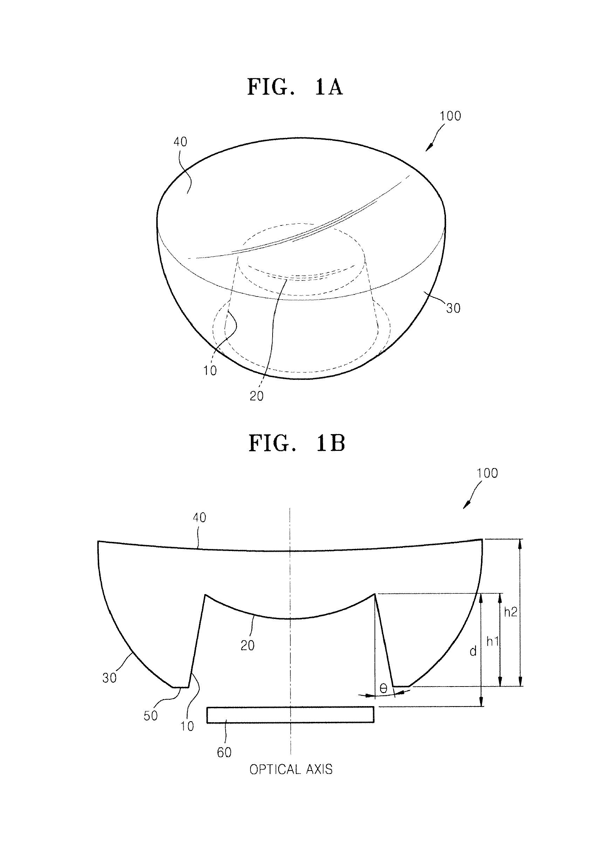

FIG. 1A is a schematic perspective view of a flash lens 100 according to an embodiment of the present invention, and FIG. 1B is a sectional view of the flash lens 100.

Referring to FIGS. 1A and 1B, the flash lens 100 according to the present embodiment includes a circular first incidence surface 20 on which light emitted from a light source 60 in a center direction is incident, a second incidence surface 10 arranged to be tilted with respect to an optical axis of the flash lens 100 and on which light emitted from the light source 60 in a lateral direction is incident, a reflective surface 30 that reflects light incident thereon from the second incidence surface 10, a bottom surface 50 that connects the second incidence surface 10 and the reflective surface 30, and a circular emission surface 40 that emits light transmitted through the first incidence surface 20 and light reflected by the reflective surface 30. Furthermore, as shown in FIG. 1A, the flash lens 100 according to the present embodiment is formed to be circular or curved overall. The light source 60 may be arranged below the flash lens 100 and may be spaced apart from the first incidence surface 20. Furthermore, the light source 60 may be an LED chip. Here, the optical axis may be a center axis of the flash lens 100 and may be perpendicular to the light source 60.

The first incidence surface 20 may be circular, and may be a planar surface or a convex surface. Conventional flash lenses are manufactured to have rectangular shapes for effectively emitting light to rectangular imaging regions. However, since the first incidence surface 20 of the flash lens 100 according to the present embodiment is formed to have a circular shape, the flash lens 100 according to the present embodiment may be manufactured relatively easily and inexpensively compared to a conventional rectangular flash lenses. Furthermore, if the first incidence surface 20 is a convex surface, the convex surface may be either spherical or aspherical. Here, the term "convex surface" means that a surface is convex with respect to the light source 60 arranged below the flash lens 100, as will be described below. Light emitted from the light source 60 in the center direction may be incident on the first incidence surface 20, where the center direction may be a direction tilted with respect to the optical axis of the flash lens 100 within a range from about -45° to about +45°. In other words, the center direction may form an angle a with the optical axis of the flash lens 100 that may satisfy an inequality about -45° ≤ a ≤ about +45°. Here, a direction along the optical axis may correspond to 0°. Meanwhile, if the first incidence surface 20 is a convex surface, light incident on the first incidence surface 20 may be reflected by the first incidence surface 20 and then incident on the second incidence surface 10. Light incident on the second incidence surface 10 may be incident on the reflective surface 30, and light incident on the reflective surface 30 may be reflected to the emission surface 40. Particularly, light incident on the reflective surface 30 may be reflected toward an edge portion of the emission surface 40 and then emitted from the edge portion of the emission surface 40. Furthermore, light incident on the second incidence surface 10 may be refracted and then incident on the reflective surface 30. Therefore, a ratio of a peripheral illuminance to a center illuminance may be improved by decreasing the center illuminance of the flash lens 100 and increasing the peripheral illuminance of the flash lens 100.

Light emitted from the light source 60 in the lateral direction may be incident on the second incidence surface 10, where the lateral direction may be a direction tilted with respect to the optical axis of the flash lens 100 within a range except the range from about -45° to about +45°. In other words, the lateral direction may correspond to a direction tilted with respect to the optical axis of the flash lens 100 within a range from about -90° to about -45° or a range from about +45° to about +90°. The second incidence surface 10 may be tilted by a predetermined angle θ with respect to the optical axis of the flash lens 100. In other words, the second incidence surface 10 may be tilted such that distances between the second incidence surface 10 and the optical axis increases from a part at which the second incidence surface 10 and the first incidence surface 20 contact each other to a part at which the incidence surface 10 and the bottom surface 50 contact each other. The angle θ between the second incidence surface 10 and the optical axis of the flash lens 100 may be from about 5° to about 10°. In other words, the second incidence surface 10 may be tilted by an angle from about 5° to about 10° with respect to the optical axis. Furthermore, a top portion of the second incidence surface 10 is covered by the first incidence surface 20, and a bottom portion of the second incidence surface 10 may contact the bottom surface 50.

The reflective surface 30 may be a conic surface or an aspheric surface, and may be symmetrical around the optical axis of the flash lens 100. The reflective surface 30 may reflect light emitted from the light source 60, incident on the second incidence surface 10, and then incident on the reflective surface 30 to the emission surface 40. Furthermore, the reflective surface 30 may reflect light emitted from the light source 60, reflected by the first incidence surface 20, incident on the second incidence surface 10, and then incident on the reflective surface 30 to the emission surface 40. Meanwhile, the reflective surface 30 may totally reflect light incident thereon.

The bottom surface 50 may connect the second incidence surface 10 and the reflective surface 30 and may have a ring shape when viewed from below the flash lens 100. Furthermore, the bottom surface 50 may not be a surface having an area and may be a circle that connects the second incidence surface 10 and the reflective surface 30 to each other.

Light transmitted through the first incidence surface 20 and light reflected by the reflective surface 30 may be emitted via the emission layer 40, and the emission layer 40 may be formed to have a circular shape. In other words, light transmitted through the first incidence surface 20, light reflected by the first incidence surface 20, incident on the second incidence surface 10, and then reflected by the reflective surface 30, and light incident on the second incidence surface 10 and then reflected by the reflective surface 30 may be emitted from the emission surface 40. The emission surface 40 may be a planar surface or a convex surface. If the emission surface 40 is a convex surface, the emission surface 40 may be spherical or aspherical. The convex type emission surface 40 may improve an illuminance uniformity of the flash lens 100. In other words, the peripheral illuminance of the flash lens 100 may be improved with respect to the center illuminance of the same. In the flash lens 100 according to the present embodiment, a ratio h₁/h₂ between a length h₁ from the bottom surface 50 to an edge of the first incidence surface 20 and a length h₂ from the bottom surface 50 to an edge of the emission surface 40 may be from about 0.45 to about 0.65. Here, the edge of the first incidence surface 20 may be where the first incidence surface 20 and the second incidence surface 10 contact each other, and the edge of the emission surface 40 may be where the emission surface 40 and the reflective surface 30 contact each other. Furthermore, the flash lens 100 according to the present embodiment may be formed such that the length h₂ from the bottom surface 50 to the edge of the emission surface 40 may be less than about 1.1mm, and a flash module employing the flash lens 100 may be manufactured to have a thickness less than about 2.0mm. Furthermore, a ratioS₁/ S₂ of the curvature radius S₁ of the first incidence surface 20 to the curvature radiusS₂ of the emission surface 40 may be below or equal to 0.15, and a distance between the curvature center of the first incidence surface 20 and the curvature center of the emission surface 40 may be within a range from 0.47mm to 0.48mm.

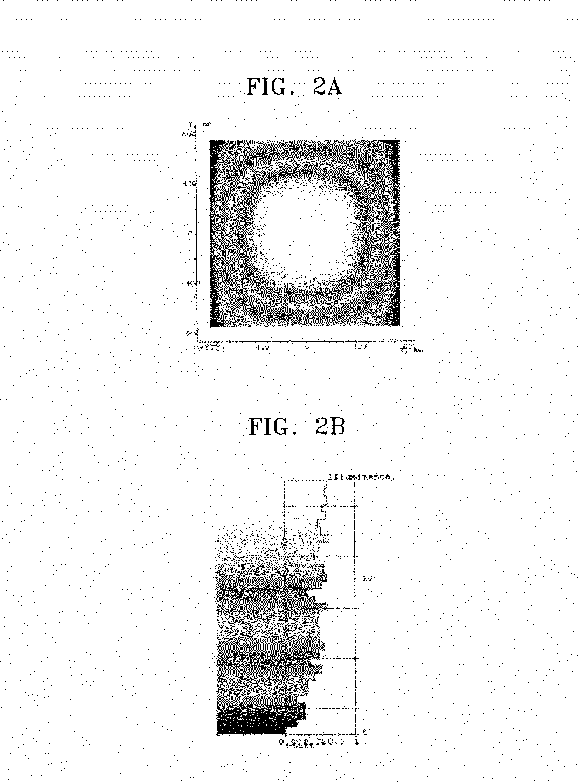

FIGS. 2A and 2B are diagrams showing illuminances of the flash lens 100 according to an embodiment of the present invention. In the embodiment of FIGS. 2A and 2B, the length h₂ from the bottom surface 50 to the edge of the emission surface 40 is about 0.95mm.

FIG. 2A shows illuminances of the flash lens 100 on a region of an x-y plane perpendicular to and about 1 m away from the flash lens 100, and FIG. 2B shows a distribution of the illuminances shown in FIG. 2A, that is, the illuminance uniformity of the flash lens 100. FIG. 2B shows ratios of each of illuminances shown in FIG. 2A and the ratios are determined by dividing the region shoing in FIG. 2A into a plurality of cells, counting a number of cells having specific illuminances, and calculating each ratio of the number of cells having the specific illuminance to the number of total cells. A left portion of FIG. 2B shows colors corresponding to 32 illuminances of light emitted from the flash lens 100, and a right portion of FIG. 2B shows a distribution of the illuminances. Detailed descriptions thereof will be given below. Referring to FIGS. 2A and 2B, the illuminance uniformity of the flash lens 100 according to the present embodiment is about 69%, and thus an illuminance uniformity similar to that of a conventional flash lens may be embodied. Here, the illuminance uniformity of the flash lens 100 refers to a ratio of the peripheral illuminance of the flash lens 100 and the center illuminance of the flash lens 100 with respect to a region on an x-y plane perpendicular to and 1 m away from the flash lens 100. A low illuminance uniformity means that a peripheral illuminance is relatively low compared to a center illuminance, and thus a peripheral portion of a photograph may become dark. Therefore, a high illuminance uniformity is advantageous for uniform brightness of a photograph. According to the present embodiment, the flash lens 100 may be slimmer than a conventional flash lens without sacrificing illumination and illuminance uniformity. Furthermore, a flash lens according to the present invention may be manufactured to have a circular shape. Therefore, a flash lens according to the present invention may be manufactured relatively easily and inexpensively compared to a conventional rectangular flash lens. In other words, in the case of a rectangular flash lens, it is more difficult to fabricate a mold. Furthermore, since surfaces of the rectangular flash lens are asymmetrical with respect to each other, it is necessary to consider directivity of the rectangular flash lens during a process of manufacturing a flash module employing the same. Furthermore, a correlated color temperature (CCT) uniformity may be improved compared to a conventional rectangular flash lens.

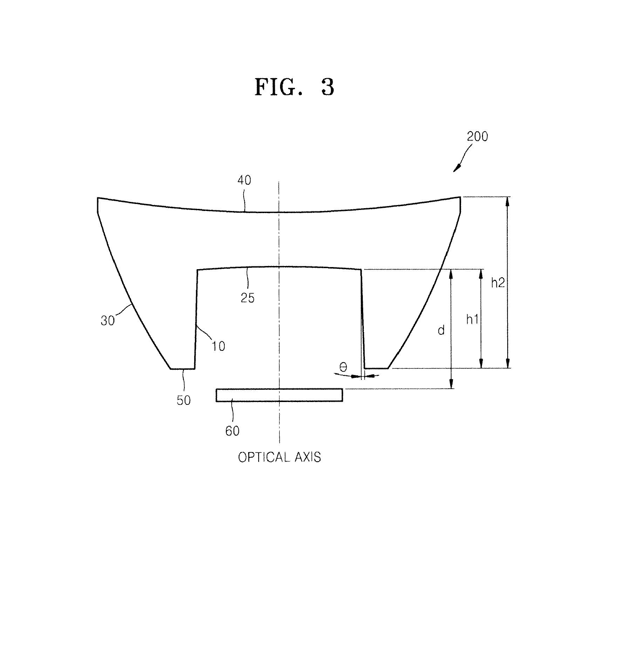

FIG. 3 is a schematic sectional view of a flash lens 200 according to another embodiment of the present invention. Referring to FIG. 3, the flash lens 200 according to the present embodiment includes a circular first incidence surface 25 on which light emitted from the light source 60 in a center direction is incident, the second incidence surface 10, which is arranged to be tilted with respect to an optical axis of the flash lens 200 and on which light emitted from the light source 60 in a lateral direction is incident, the reflective surface 30, which reflects light incident thereon from the second incidence surface 10, the bottom surface 50, which connects the second incidence surface 10 and the reflective surface 30, and the circular emission surface 40, which emits light transmitted through the first incidence surface 25 and light reflected by the reflective surface 30 are output.

The light source 60 may be arranged below the flash lens 200, and more particularly, may be arranged below the first incidence surface 25 to be apart therefrom. Furthermore, the light source 60 may be, for example, a LED chip.

The first incidence surface 25 may be circular, and may be a planar surface or a concave surface. Conventional flash lenses are manufactured to have rectangular shapes for effectively emitting light to rectangular imaging regions. However, since the first incidence surface 25 of the flash lens 200 according to the present embodiment is formed to have a circular shape, the flash lens 200 according to the present embodiment may be manufactured relatively easily and inexpensively compared to conventional rectangular flash lenses. Furthermore, if the first incidence surface 25 is a concave surface, the concave surface may be either spherical or aspherical, Here, the term "concave surface" means that the first incidence surface 25 is concave with respect to the light source 60 arranged below the flash lens 200, as described below.

Light emitted from the light source 60 in the center direction may be incident on the first incidence surface 25, and the center direction may be a direction tilted with respect to the optical axis of the flash lens 200 within a range from about -45° to about +45°. In other words, the center direction may form an angle a with the optical axis of the flash lens 200 that may satisfy an inequality about -45° ≤ a ≤ about +45°. Here, a direction along the optical axis may correspond to 0°. Meanwhile, if the first incidence surface 25 is a concave surface, reflection of light incident on the first incidence surface 25 by the first incidence surface 25 may be reduced compared to that of FIGS. 1A and1 B. In other words, emission of light reflected by the first incidence surface 25 from the emission surface 40 via the second incidence surface 10 and the reflective surface 30 may be reduced compared to that of FIGS. 1A and 1B. Therefore, light emitted from the light source 60 may be emitted from the emission surface 40 directly through the first incidence surface 25. As a result, a light path may be simplified, and thus loss of light due to reflection of light on the reflective surface 30 may be reduced. Therefore, a flash lens according to the present invention may be manufactured relatively easily without sacrificing illumination and illuminance uniformity compared to a conventional rectangular flash lens. Furthermore, a CCT uniformity may be improved compared to a conventional rectangular flash lens. Meanwhile, a distance d between the light source 60 and the first incidence surface 25 is from about 0.4mm to about 4.5mm.

Light emitted from the light source 60 in the lateral direction may be incident on the second incidence surface 10, where the lateral direction may be a direction tilted with respect to the optical axis of the flash lens 200 within a range except the range from about -45° to about +45°. In other words, the lateral direction may correspond to a direction tilted with respect to the optical axis of the flash lens 200 within a range from about -90° to about -45° or a range from about +45° to about +90°. The second incidence surface 10 may be tilted by a predetermined angle θ with respect to the optical axis of the flash lens 200. In other words, the second incidence surface 10 may be tilted such that distances between the second incidence surface 10 and the optical axis increases from a part at which the second incidence surface 10 and the first incidence surface 25 contact each other to a part at which the incidence surface 10 and the bottom surface 50 contact each other. The angle θ between the second incidence surface 10 and the optical axis of the flash lens 200 may be from about 5° to about 10°. In other words, the second incidence surface 10 may be tilted by an angle from about 5° to about 10° with respect to the optical axis. Furthermore, the top portion of the second incidence surface 10 is covered by the first incidence surface 25, and the bottom portion of the second incidence surface 10 may contact the bottom surface 50.

The reflective surface 30 may be a conic surface or an aspheric surface, and may be symmetrical around the optical axis of the flash lens 200. The reflective surface 30 may reflect light emitted from the light source 60, incident on the second incidence surface 10, and then incident on the reflective surface 30 to the emission surface 40. Furthermore, the reflective surface 30 may reflect light emitted from the light source 60, reflected by the first incidence surface 25, incident on the second incidence surface 10, and then incident on the reflective surface 30 to the emission surface 40. Meanwhile, the reflective surface 30 may totally reflect light incident thereon.

The bottom surface 50 may connect the second incidence surface 10 and the reflective surface 30 and may have a ring shape when viewed from below the flash lens 200. Furthermore, the bottom surface 50 may not be a surface having an area and may be a circle that connects the second incidence surface 10 and the reflective surface 30 to each other.

Light transmitted through the first incidence surface 25 and light reflected by the reflective surface 30 may be emitted via the emission layer 40, and the emission layer 40 may be formed to have a circular shape. In other words, light transmitted through the first incidence surface 25, light reflected by the first incidence surface 25, incident on the second incidence surface 10, and then reflected by the reflective surface 30, and light incident on the second incidence surface 10 and then reflected by the reflective surface 30 may be emitted from the emission surface 40. The emission surface 40 may be a planar surface or a convex surface. If the emission surface 40 is a convex surface, the emission surface 40 may be spherical or aspherical. The convex type emission surface 40 may improve an illuminance uniformity of the flash lens 200. In other words, a peripheral illuminance of the flash lens 200 may be improved with respect to a center illuminance of the same. In the flash lens 200 according to the present embodiment, a ratio h₁/h₂ between a length h₁ from the bottom surface 50 to an edge of the first incidence surface 25 and a length h₂ from the bottom surface 50 to the edge of the emission surface 40 may be from about 0.45 to about 0.65. Here, the edge of the first incidence surface 25 may be where the first incidence surface 25 and the second incidence surface 10 contact each other, and the edge of the emission surface 40 may be where the emission surface 40 and the reflective surface 30 contact each other. Furthermore, the flash lens 200 according to the present embodiment may be formed such that the length h₂ from the bottom surface 50 to the edge of the emission surface 40 may be less than about 1.1mm, and a flash module employing the flash lens 200 may be manufactured to have a thickness less than about 2.0mm.

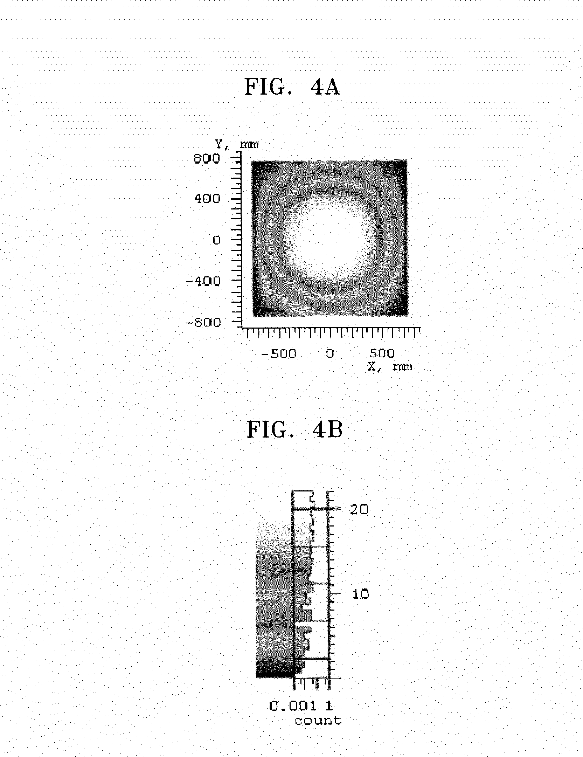

FIGS. 4A and 4B are diagrams showing illuminances of the flash lens 200 according to an embodiment of the present invention.

FIG. 4A shows illuminances of the flash lens 200 on a region of an x-y plane perpendicular to and 1 m away from the flash lens 200, and FIG. 4B shows a distribution of the illuminances shown in FIG. 4A, that is, the illuminance uniformity of the flash lens 200. Referring to FIGS. 4A and 4B, an illumination of the flash lens 200 according to the present embodiment is about 23 lux, which is similar to that of a conventional flash lens, that is, about 22 lux. A flash lens according to the present invention may be manufactured to have a circular shape. Therefore, a flash lens according to the present invention may be manufactured relatively easily and inexpensively without sacrificing illumination and illuminance uniformity compared to a conventional rectangular flash lens. In other words, in the case of a rectangular flash lens, it is more difficult to fabricate a mold. Furthermore, since surfaces of the rectangular flash lens are asymmetrical with respect to each other, it is necessary to consider directivity of the rectangular flash lens during a process of manufacturing a flash module employing the same. Furthermore, a CCT uniformity may be improved compared to a conventional rectangular flash lens.

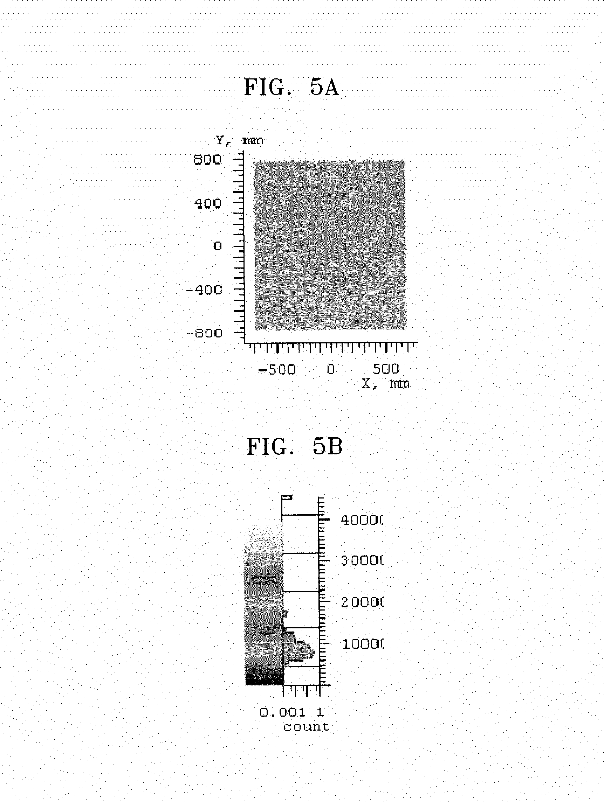

FIGS. 5A and 5B are diagrams showing CCTs of the flash lens 200 according to an embodiment of the present invention. FIG. 5A shows CCTs of the flash lens 200 on a region of an x-y plane perpendicular to and about 1m away from the flash lens 200, and FIG. 5B shows a distribution of the CCTs shown in FIG. 5A. Referring to FIGS. 5A and 5B, the CCT distribution of the flash lens 200 according to the present embodiment is more uniform than that of a conventional flash lens, In other words, a flash lens according to the present embodiment exhibits higher CCT uniformity than a conventional flash lens. Therefore, a flash lens according to the present invention may be manufactured relatively easily and inexpensively without sacrificing illumination and illuminance uniformity compared to a conventional rectangular flash lens. Furthermore, a CCT uniformity may be improved compared to a conventional rectangular flash lens.

As shown in FIG. 1B, a flash module according to an embodiment of the present invention may include the flash lens 100 and the light source 60 as an LED chip. Furthermore, although not shown, the flash module may further include a housing in which the LED chip 60 is mounted, and the flash lens 100 may be disposed in the housing. The flash module according to the present embodiment may include the flash lens 100 having a thickness less than about 1.1mm, and an overall thickness of the flash module may be less than about 2.0mm. Despite being slimmer than a conventional rectangular flash lens, the illuminance uniformity of the flash lens 100 according to the present embodiment may be similar to that of a conventional rectangular flash lens. Furthermore, since the flash lens 100 according to the present embodiment is manufactured to have a circular shape, the flash lens 100 according to the present embodiment may be manufactured relatively easily and inexpensively compared to a conventional rectangular flash lens. Furthermore, in the case of a flash module including the flash lens 200 according to another embodiment of the present invention, an illumination of the flash lens 200 is similar to that of a conventional rectangular flash lens. Furthermore, since the flash lens 200 is manufactured to have a circular shape, it is not necessary to consider directivity of the flash lens 200. Therefore, the flash lens 200 may be manufactured relatively easily and inexpensively. Furthermore, a CCT uniformity may be improved compared to a conventional rectangular flash lens.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A flash lens comprising:
a circular first incidence surface on which light emitted from a light source in a center direction is incident;
a second incidence surface arranged to be tilted with respect to an optical axis and on which light emitted from the light source in a lateral direction is incident;
a reflective surface that reflects light incident from the second incidence surface;
a bottom surface that connects the second incidence surface and the reflective surface; and
a circular emission surface that emits light transmitted through the first incidence surface and light reflected by the reflective surface.

2. The flash lens of claim 1, wherein the reflective surface is a conic surface or an aspheric surface.

3. The flash lens of claim 1, wherein the first incidence surface is a convex surface.

4. The flash lens of claim 3, wherein the first incidence surface is spherical or aspherical.

5. The flash lens of claim 1, wherein an angle by which the second incidence surface is tilted with respect to the optical axis is from 5° to 10°.

6. The flash lens of claim 1, wherein a ratio between a length from the bottom surface to an edge of the first incidence surface and a length from the bottom surface to an edge of the emission surface is from 0.45 to 0.65.

7. The flash lens of claim 1, wherein the first incidence surface is a concave surface.

8. The flash lens of claim 7, wherein the first incidence surface is spherical or aspherical.

9. The flash lens of claim 1, wherein the emission surface is a convex surface.

10. The flash lens of claim 9, wherein the emission surface is spherical or aspherical.

11. The flash lens of claim 1, wherein a distance between the light source and the first incidence surface is from 0.4mm to 4.5mm.

12. The flash lens of claim 1, wherein the center direction is a direction tilted with respect to the optical axis within a range from -45° to +45°.

13. The flash lens of claim 1, wherein the lateral direction is a direction tilted with respect to the optical axis within a range except a range from -45° to +45°.

14. The flash lens of claim 1, wherein a distance between the curvature center of the first incidence surface and the curvature center of the emission surface is within a range from 0.47 mm to 0.48mm.

15. A flash module comprising:
an LED chip; and
the flash lens of claim 1 that is arranged above the LED chip.
